(19) **Europäisches Patentamt / European Patent Office / Office européen des brevets**

(11) **EP 4 266 067 B1**

(12) # EUROPEAN PATENT SPECIFICATION

(45) Date of publication and mention
of the grant of the patent:
**14.05.2025 Bulletin 2025/20**

(21) Application number: **20965970.5**

(22) Date of filing: **17.12.2020**

(51) International Patent Classification (IPC):
**G01R 27/26** *(2006.01)*      **G01R 31/72** *(2020.01)*

(52) Cooperative Patent Classification (CPC):
**G01R 31/72**

(86) International application number:
**PCT/JP2020/047229**

(87) International publication number:
**WO 2022/130583 (23.06.2022 Gazette 2022/25)**

(54) **TEMPERATURE INCREASE TESTING METHOD FOR REACTORS**

VERFAHREN ZUR TEMPERATURSTEIGERUNGSPRÜFUNG VON REAKTOREN

PROCÉDÉ D'ESSAI D'AUGMENTATION DE TEMPÉRATURE POUR RÉACTANCES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.10.2023 Bulletin 2023/43**

(73) Proprietor: **Nissin Electric Co., Ltd.**
**Kyoto-shi, Kyoto 615-8686 (JP)**

(72) Inventors:
• **MAEJI, Hiroaki**
**Kyoto-shi, Kyoto 615-8686 (JP)**
• **KUWATA, Minoru**
**Kyoto-shi, Kyoto 615-8686 (JP)**

(74) Representative: **Becker, Eberhard**
**Becker Kurig & Partner**
**Patentanwälte mbB**
**Bavariastraße 7**
**80336 München (DE)**

(56) References cited:
WO-A1-2011/118507    WO-A1-2012/137494
GB-A- 2 556 308      JP-A- 2007 081 184
JP-A- 2008 122 210   JP-A- 2008 141 012
JP-A- 2012 026 960   JP-A- 2016 133 355
JP-A- 2016 133 355   JP-Y1- S 499 938

• ARRI E ET AL: "MEASUREMENT OF TRANSFORMER POWER LOSSES AND EFFICIENCY IN REAL WORKING CONDITIONS", IEEE TRANSACTIONS ON INSTRUMENTATION AND MEASUREMENT, IEEE, USA, vol. 40, no. 2, 1 April 1991 (1991-04-01), pages 384 - 387, XP000234278, ISSN: 0018-9456, DOI: 10.1109/ TIM.1990.1032966
• TANAKA, TOMOKI ET AL.: "Loss analysis of the reactor-DC power supply experiment under forced convection", ANNUAL MEETING RECORD IEE JAPAN 2014 (IEEJ), 20 March 2014 (2014-03-20), JP, pages 123 - 124, XP009538274

**Description**

Technical Field

The present invention relates to a temperature increase testing method for a reactor into which currents of a plurality of frequencies flow.

Related Art

Various methods are available for testing the performance of a reactor. Among these methods, a temperature increase testing method that tests a temperature increase of a reactor during use is described in Non-Patent Document 1. Non-Patent Document 1 specifies that, as a test simulating the case where a harmonic current is superimposed onto a fundamental wave current and flows in, energization under condition (1) or (2) below is performed.

Herein, an example of the case of allowable current type I is illustrated. (1) A fifth harmonic current having a fifth harmonic content at a fundamental wave current ratio 35% is superimposed onto a rated current at a rated frequency to continuously energize a reactor (hereinafter referred to as Conventional test X). (2) A reactor is continuously energized with a fundamental wave current with which a loss of the reactor is equivalent to a total loss described below (hereinafter referred to as Conventional test Y). The total loss is a sum of an actual measured loss of the reactor during energization of the rated current at the rated frequency and an actual measured loss of the reactor during energization of the fifth harmonic current at a fundamental wave current ratio 35%.

Related Art Documents

Non-Patent Document

Non-Patent Document 1: Japanese Industrial Standards Committee "JIS High Voltage and Extra High Voltage Phase-Advancing Capacitors and Attached Apparatus--Part 2: Series Reactors (JIS C 4902-2: 2010)"
Patent document JP 2016 133355 A discloses an iron loss measurement method.

SUMMARY OF INVENTION

Problem to Be Solved by Invention

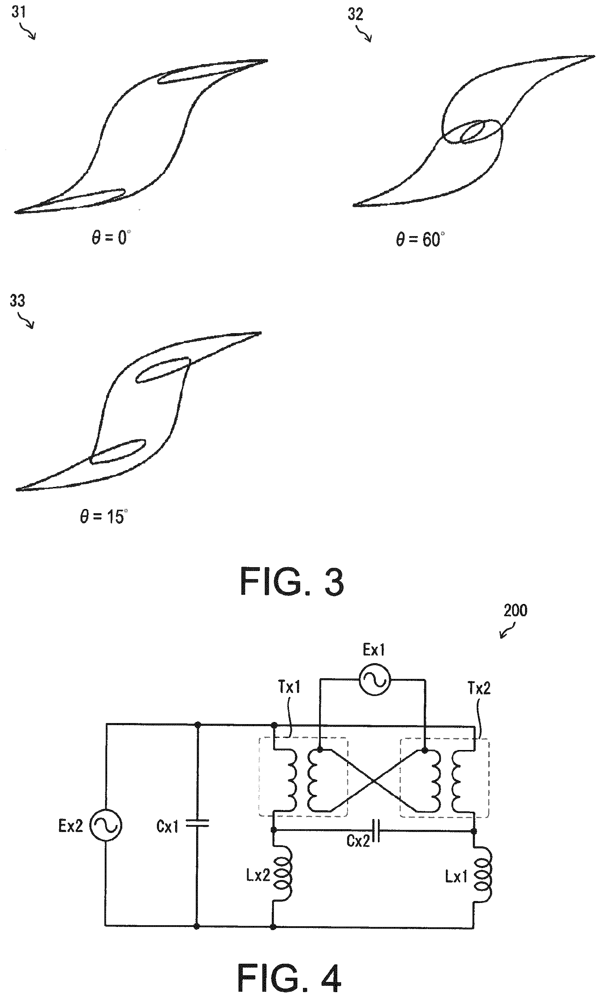

Conventional test X can simulate the energization state that corresponds to the actual usage conditions, but there is a problem that currents mix into a fundamental wave power supply and a harmonic power supply from each other in a testing circuit. A circuit shown in FIG. 4, for example, may be adopted as a circuit configuration for avoiding current mixing. However, there is a problem that a test performed using the circuit shown in FIG. 4 becomes large in scale.

Conventional test Y supplies the total loss only with the fundamental wave current without reflecting frequency dependency of a copper loss and an iron loss included in the loss of the reactor. Thus, there is a problem that the copper loss and the iron loss in the state in which the fundamental wave and the harmonic are superimposed are not accurately simulated.

An aspect of the present invention aims to realize a temperature increase test for a reactor that corresponds to the actual usage conditions with a simple testing circuit.

Means for Solving Problem

To solve the above problems, a temperature increase testing method for a reactor according to an aspect of the present invention includes: a step of calculating a target copper loss based on a copper loss during energization of a fundamental wave current at a predetermined current value and respective copper losses during energization of respective harmonic currents of predetermined orders at predetermined current values; a step of calculating a target iron loss based on an iron loss during energization of the fundamental wave current and iron losses during energization of the respective harmonic currents; a step of calculating a frequency and a current value of a current that creates the target copper loss and the target iron loss, respectively as a test frequency and a test current value; and a step of energizing the reactor with a test current having the test frequency and the test current value, until a temperature of a predetermined part of the reactor becomes constant.

Effect of Invention

According to an aspect of the present invention, it is possible to realize a temperature increase test for a reactor that corresponds to the actual usage conditions with a simple testing circuit.

BRIEF DESCRIPTION OF DRAWINGS

FIG. 1 is a circuit diagram showing a testing circuit of a temperature increase testing method according to Embodiment 1 of the present invention.
FIG. 2 is a diagram showing a comparison between examples of each loss during energization in temperature increase tests according to Conventional test X, Conventional test Y, Embodiment 1, and Embodiment 2.
FIG. 3 is a diagram showing examples of a hysteresis curve of a distorted wave magnetic flux including a third harmonic.
FIG. 4 is a circuit diagram showing a circuit example for performing Conventional test X.

DESCRIPTION OF EMBODIMENTS

(Embodiment 1)

Hereinafter, Embodiment 1 of the present invention will be described in detail. A series reactor for a phase-advancing capacitor or a so-called filter reactor is used in combination with a capacitor. Thus, when the capacitor and the reactor are used in combination, a harmonic current flows through the reactor in addition to a fundamental wave current.
A temperature increase testing method according to the present invention is a temperature increase testing method for a reactor capable of simulating a temperature increase in a state in which a harmonic current is superimposed onto a fundamental wave current as described above. Further, there are various types of reactors, such as an air-core type, a magnetic shielding air-core type, and a gapped iron core type. The temperature increase testing method according to the present invention targets a reactor (magnetic shielding air-core type, gapped iron core type) mainly composed of a winding and an iron core using electromagnetic steel plates.

<Configuration of testing circuit 100>

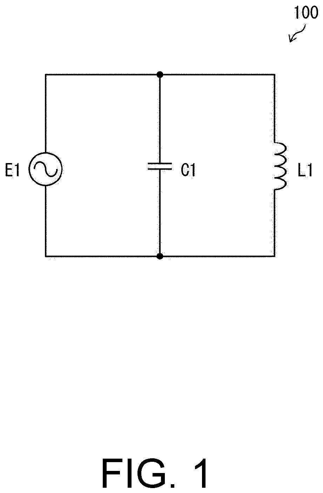

FIG. 1 is a circuit diagram showing a testing circuit 100 of the temperature increase testing method according to Embodiment 1 of the present invention. As shown in FIG. 1, the testing circuit 100 includes a frequency-variable power supply E1, a compensation capacitor C1, and a test reactor L1. The testing circuit 100 is a circuit that performs a temperature increase test of the test reactor L1.
A frequency and a current value of the frequency-variable power supply E1 are variable. The frequency-variable power supply E1 energizes the test reactor L1 with a test current having a test frequency fex and a test current value Iex (to be described later). The compensation capacitor C1 reduces the power capacity of the frequency-variable power supply E1 for energizing the test reactor L1 with the required current.

<Flow of temperature increase testing method>

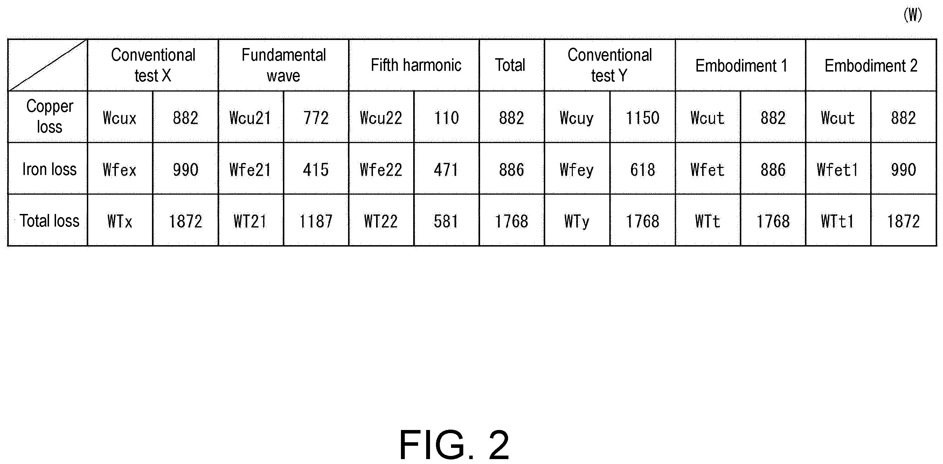

A flow of the temperature increase testing method according to Embodiment 1 will be described below with reference to FIG. 1 and FIG. 2. FIG. 2 is a diagram showing a comparison between examples of each loss during energization in temperature increase tests according to Conventional test X, Conventional test Y, Embodiment 1, and Embodiment 2.
With the frequency-variable power supply E1, the test reactor L1 is energized with a fundamental wave current at a predetermined first current value i21, and a loss (total loss WT21) of the test reactor L1 during energization of the fundamental wave current is measured (step S1). The first current value i21 is, for example, a rated current value of the test reactor L1.
Further, the test reactor L1 is energized with a harmonic current at a second current value i22, and a loss (total loss WT22) during energization of the harmonic current is measured (step S2). The harmonic current may be, for example, a fifth harmonic of the fundamental wave, and may have a current value at a fundamental wave current ratio 35%.
Next, based on a copper loss Wcu21 during energization of the fundamental wave current at the first current value i21 and a copper loss Wcu22 during energization of the harmonic current at a predetermined second current value i22, a target copper loss Wcut is calculated (step S3). More specifically, the target copper loss Wcut is obtained as a sum of the copper loss Wcu21 during energization of the fundamental wave current and the copper loss Wcu22 during energization of the harmonic current.

The copper loss Wcu21 during energization of the fundamental wave current and the copper loss Wcu22 during energization of the harmonic current are obtained in advance by calculation. Specifically, they may be obtained using Formula (1) below.

[Math. 1]

$$(\text{Formula 1}) \quad W_{cu} = R_{dc} \times I^2 + R_e \times I^2 \times f^2$$

In Formula (1), Wcu represents a copper loss, Rdc represents a direct current resistance of the winding, Re represents an alternating current resistance coefficient corresponding to an eddy current loss of the winding, f represents a frequency, and I represents a current value. The direct current resistance Rdc is an actual measured value of the test reactor L1, and the alternating current resistance coefficient Re may be obtained by simulation using a finite element method.

Next, based on an iron loss Wfe21 during energization of the fundamental wave current and an iron loss Wfe22 during energization of the harmonic current, a target iron loss Wfet is calculated (step S4). More specifically, in Embodiment 1, the target iron loss Wfet is obtained as a sum of the iron loss Wfe21 during energization of the fundamental wave current and the iron loss Wfe22 during energization of the harmonic current.

Herein, the iron loss Wfe21 during energization of the fundamental wave current is obtained by subtracting the copper loss Wcu21 during energization of the fundamental wave current from the total loss WT21 during energization of the fundamental wave current. The iron loss Wfe22 during energization of the harmonic current is obtained by subtracting the copper loss Wcu22 during energization of the harmonic current from the total loss WT22 during energization of the harmonic current.

In Embodiment 1, as described above, each measured total loss is separated into the iron loss and the copper loss by calculation. Specifically, the measured total loss WT21 is separated into the copper loss Wcu21 and the iron loss Wfe21, and the measured total loss WT22 is separated into the copper loss Wcu22 and the iron loss Wfe22. In the case where the target of the temperature increase test is a transformer, since there are two sets of windings, the loss at the time when the other winding is opened and there is no load may be taken as the iron loss, and the loss at the time when the other winding is short-circuited may be taken as the copper loss. However, in the case of a reactor, since there is only one set of winding, it is not possible to individually measure the iron loss and the copper loss. Thus, it is required to separate the iron loss and the copper loss by calculation as described above.

Next, a frequency and a current value of a current that creates the target copper loss Wcut and the target iron loss Wfet are respectively calculated as a test frequency fex and a test current value Iex (step S5). The test frequency fex and the test current value Iex may be calculated according to simultaneous equations of Formula (2) below.

[Math. 2]

$$(\text{Formula 2}) \quad \begin{cases} W_{cu} = R_{dc} \times I^2 + R_e \times I^2 \times f^2 \\ W_{fe} = K_h \times I^n \times f + K_e \times I^2 \times f^2 \end{cases}$$

In Formula (2), Rdc is a direct current resistance of the winding, Re is an alternating current resistance coefficient corresponding to an eddy current loss of the winding, and as described above, these values are known. Wfe is an iron loss. n is a Steinmetz's constant (approximately 1.6) and is determined by the material constituting the test reactor L1. Kh is a hysteresis loss coefficient, and Ke is an eddy current loss coefficient, which are coefficients obtained based on the iron loss Wfe21 during energization of the fundamental wave current and the iron loss Wfe22 during energization of the harmonic current. Thus, the unknowns in Formula (2) are the frequency and the current, which are obtained by solving these simultaneous equations respectively as the test frequency fex and the test current value Iex.

In the example of Embodiment 1 shown in FIG. 2, the test frequency fex serving as a solution to the simultaneous equations takes a value between a fundamental wave frequency 50 Hz and a fifth harmonic frequency 250 Hz and is calculated to be approximately 130 Hz, for example.

Next, the test reactor L1 is energized with a test current having the test frequency fex and the test current value Iex, and the energization is performed until the temperature of a predetermined part of the test reactor L1 becomes constant (step S6). The temperature of the predetermined part is, for example, the temperature of the winding of the test reactor L1. Also, it may be the temperature of the iron core. Furthermore, in the case where the test reactor L1 is an oil-filled reactor, the temperature of the predetermined part may be the temperature of the insulating oil. In this manner, the temperature increase test according to Embodiment 1 is performed.

The above description pertains to the case where one harmonic current is superimposed onto the fundamental wave current. In contrast, calculation of the target copper loss Wcut and the target iron loss Wfet in the case where one or more harmonic currents are superimposed onto the fundamental wave current is as follows.

In step S3, the calculation of the target copper loss Wcut is performed based on the copper loss Wcu21 during energization of the fundamental wave current at the predetermined first current value i21, and copper losses Wcu22m. The copper losses Wcu22m are respective copper losses during energization of respective harmonic currents of predetermined orders at predetermined second current values i22m. Herein, m represents the order of the selected harmonic current. The copper loss Wcu22m represents each copper loss during energization of a harmonic current having the selected order. Thus, a copper loss Wcu22m is present for each selected order.

For example, a case where the harmonic current superimposed onto the fundamental wave current is a fifth harmonic and a seventh harmonic will be described. In this case, the target copper loss Wcut is calculated based on the copper loss Wcu21 during energization of the fundamental wave current at the predetermined first current value i21, a copper loss Wcu225 during energization of a fifth harmonic current at a predetermined second current value i225, and a copper loss Wcu227 during energization of a seventh harmonic current at a predetermined second current value i227. Specifically, the target copper loss Wcut is obtained as a sum of the copper loss Wcu21 during energization of the fundamental wave current and the copper losses Wcu22m during energization of the respective harmonic currents of the predetermined orders. In the above example, the target copper loss Wcut is obtained based on a sum of the copper loss Wcu21, the copper loss Wcu225, and the copper loss Wcu227.

Further, in step S4, the target iron loss Wfet is obtained based on the iron loss Wfe21 during energization of the fundamental wave current at the predetermined first current value i21, and iron losses Wfe22m during energization of respective harmonic currents of predetermined orders.

For example, a case where the harmonic current superimposed onto the fundamental wave current is a fifth harmonic and a seventh harmonic will be described. In this case, the target iron loss Wfet is calculated based on the iron loss Wfe21 during energization of the fundamental wave current at the predetermined first current value i21, an iron loss Wfe225 during energization of a fifth harmonic current at a predetermined second current value i225, and an iron loss Wfe227 during energization of a seventh harmonic current at a predetermined second current value i227. In other words, the target iron loss Wfet is obtained as a sum of the iron loss Wfe21 during energization of the fundamental wave current and the iron losses Wfe22m during energization of the respective harmonic currents of the predetermined orders. In the above example, the target iron loss Wfet is obtained based on a sum of the iron loss Wfe21, the iron loss Wfc225, and the iron loss Wfe227.

Herein, the iron losses Wfe22m during energization of the respective harmonic currents of the predetermined orders are obtained by subtracting the copper losses Wcu22m during energization of the respective harmonic currents of the predetermined orders from total losses WT22m during energization of the respective harmonic currents of the predetermined orders. Specifically, the iron loss Wfe225 is obtained by subtracting the copper loss Wcu225 from a total loss WT225 during energization of the fifth harmonic current. Similarly, the iron loss Wfe227 is obtained by subtracting the copper loss Wcu227 from a total loss WT227 during energization of the seventh harmonic current. In step S2, the total loss WT225 and the total loss WT227 are obtained by energizing the test reactor L1 respectively with harmonic currents of the predetermined orders (fifth harmonic current and seventh harmonic current) at predetermined current values, and measuring the losses during energization of the respective harmonic currents of the predetermined orders.

In this manner, in the case of simulating superimposition of one or more harmonic currents onto the fundamental wave current, calculations are performed based on the copper loss, the iron loss, and the total loss for each harmonic current having any selected order, and the copper loss, the iron loss, and the total loss during energization of the fundamental wave current.

<Verification of temperature increase testing method>

The temperature increase testing method according to Embodiment 1 is verified below based on FIG. 2. In FIG. 2, the rated frequency of the fundamental wave current is 50 Hz. Conventional test X is performed by superimposing a fifth harmonic current having a fifth harmonic content at a fundamental wave ratio 35% onto a fundamental wave current 100% to energize the test reactor, and supplying a total loss WTx.

In the column of Conventional test X in FIG. 2, the copper loss Wcux calculated according to the above calculation method, and the iron loss Wfex obtained as a difference between the total loss WTx and the copper loss Wcux are shown together. Conventional test X is a test that is performed by actually energizing the test reactor L1 with a current in which a harmonic is superimposed onto the fundamental wave current to simulate the actual usage conditions.

The ratios of the copper loss Wcux and the iron loss Wfex to the total loss WTx in Conventional test X can be said to simulate the actual usage conditions. In other words, as the value of each loss in each temperature increase test approaches the value of Conventional test X, it can be said that the energization to the test reactor L1 with the test current has more faithfully simulated the actual usage conditions.

However, in Conventional test X, it is required to superimpose a harmonic onto the fundamental wave to supply to the test reactor, and there is a problem that a current flows into a fundamental wave power supply and a harmonic power supply respectively from each other. In the case of using a commercial power supply as the fundamental wave power supply, there is a problem that a harmonic current flows out to the system of the commercial power supply. Further, to secure the test current flowing into the test reactor even if the harmonic current flows out to the commercial power supply system, it is required to increase the power capacity of the harmonic power supply.

Thus, to prevent mutual current inflow between the fundamental wave power supply and the harmonic power supply, a circuit configuration for testing shown in FIG. 4 is known. In this circuit configuration, since two superimposition transformers (superimposition transformers Tx1 and Tx2) and two test reactors (test reactors Lx1 and Lx2) are required, the testing equipment becomes large in scale. In particular, since two test reactors with the same configuration are required, there is a problem that Conventional test X cannot be performed in the case where only one test reactor can be economically prepared.

Next, Conventional test Y is verified. As described above, Conventional test Y performs energization only with the fundamental wave current without reflecting the frequency dependency of the copper loss and the iron loss included in the loss of the reactor. Specifically, the test reactor L1 is energized with a fundamental wave current at a predetermined first current value i21, and a total loss WT21 during energization of the fundamental wave current is obtained. Further, the test reactor L1 is energized with a harmonic current at a second current value i22, and a total loss WT22 during energization of the harmonic current is obtained. Up to this point, the flow is the same as that of the temperature increase testing method according to Embodiment 1.

Subsequently, in Conventional test Y, a target total loss WTy is obtained by adding the total loss WT21 during energization of the fundamental wave current and the total loss WT22 during energization of the harmonic current, and the test reactor L1 is energized with only the fundamental wave current such that the loss of the test reactor L1 becomes the target total loss WTy.

However, as is clear from Formula (2) above, the frequency characteristics are different between the copper loss and the iron loss. Thus, in Conventional test Y, it is not possible to sufficiently simulate the actual usage conditions in which two or more currents of different frequencies are superimposed. More specifically, in Conventional test Y, the copper loss Wcuy becomes a larger loss compared to the actual usage, and the iron loss Wfey becomes a smaller loss compared to the actual usage.

In FIG. 2, in contrast to Conventional test X in which the copper loss Wcux is 882W and the iron loss Wfex is 990W, Conventional test Y is significantly different with the copper loss Wcuy being 1150W and the iron loss Wfey being 618W. The copper loss is approximately 1.3 times (1150/882) of Conventional test X, and the iron loss is approximately 0.6 times (618/990) of Conventional test X. It is understood that Conventional test Y cannot sufficiently simulate the actual usage conditions of the reactor.

Thus, to pass the temperature increase test in Conventional test Y, it is inevitable to adopt an excessive design for the winding of the reactor, such as excessively reducing a winding resistance. Further, regarding the iron loss, since a loss of the actual usage conditions cannot be supplied during the temperature increase test, there is a problem that the verification relating to the iron core of the reactor is insufficient even if the temperature increase test is passed.

Next, the temperature increase testing method according to Embodiment 1 is verified. In Conventional test Y, energization has been performed with a fundamental wave current such that the loss of the test reactor L1 becomes the target total loss WTy. In other words, in Conventional test Y, regarding the test current, the frequency has been fixed at the same as the fundamental wave, and only the current value has been adjusted. In contrast, in the temperature increase testing method according to Embodiment 1, by adjusting not only the current value but also the frequency of the test current, it is possible to supply a loss that corresponds to the actual usage conditions.

As shown in FIG. 2, the target copper loss Wcut of Embodiment 1 is consistent with the value of the copper loss Wcux in Conventional test X. The target total loss WTt is the same as the target total loss WTy in Conventional test Y. It can be said that the temperature increase testing method of Embodiment 1 can more faithfully simulate the actual usage conditions compared to Conventional test Y.

The effects of the temperature increase testing method according to Embodiment 1 are as follows. The temperature increase testing method according to Embodiment 1 can perform energization simulating the actual usage conditions without superimposing currents of different frequencies. Further, using a fundamental wave power supply and a harmonic power supply in the testing circuit, there is no problem of current inflow from each other, and it becomes possible to realize a temperature increase test with a simple circuit configuration for testing. In addition, there is also an advantage that one test reactor would be sufficient.

(Embodiment 2)

Embodiment 2 of the present invention will be described below. Embodiment 2 is different from Embodiment 1 in that the target iron loss Wfet is corrected to obtain a corrected target iron loss Wfetl (target iron loss), and the other configurations and procedures are the same as those in Embodiment 1.

Comparing the value of each loss in Embodiment 1 and Conventional test X in FIG. 2, the target iron loss Wfet of Embodiment 1 is smaller than the iron loss Wfex of Conventional test X. This is because the electromagnetic steel plate constituting the iron core has nonlinear characteristics, and an iron loss in the case of superimposition (iron loss Wfex of 990W of Conventional test X in FIG. 2) increases compared to a loss (target iron loss Wfet of 886W of Embodiment 1 in FIG. 2) obtained by adding together the iron loss during energization of the fundamental wave current and the iron loss during energization of the fifth harmonic current.

FIG. 3 is a diagram showing examples of a hysteresis curve at 50 Hz and 10 kG of a distorted wave magnetic flux including a third harmonic. As shown in FIG. 3, it is clear that the shapes of hysteresis curves 31, 32, and 33 change depending on a superimposition phase θ of the harmonic. Thus, the magnitude of the iron loss in the case of superimposing the harmonic onto the fundamental wave current varies depending on the superimposition phase of the harmonic.

In this manner, the behavior of the iron loss when superimposing the harmonic current onto the fundamental wave current is complex. However, it is possible to empirically estimate the iron loss according to superimposition test results for reactors with similar designs and the material properties of the test reactor L1. The estimation can be performed more appropriately by setting a correction coefficient of the iron loss as K and setting the corrected target iron loss Wfet1 to be supplied as a value obtained by multiplying the target iron loss Wfet in Embodiment 1 by the correction coefficient K. The correction coefficient K is a coefficient of 1 or more.

In other words, the corrected target iron loss Wfet1 is obtained by multiplying the target iron loss Wfet, which is the sum of the iron loss Wfe21 during energization of the fundamental wave current and the iron loss Wfe22 during energization of the harmonic current, by a specific coefficient K. The correction coefficient K is not constant but varies depending on the magnetic flux density of the fundamental wave, the magnetic flux density of the harmonic, the superimposition phase, the material properties, etc. in the reactor.

Thus, by creating a database of the values of the correction coefficient K for reactors of various designs, it becomes possible to determine the correction coefficient K for the test reactor L1 according to the database. By determining the correction coefficient K based on the database with reference to the design conditions of the test reactor L1, it becomes possible to obtain the test current value and the test frequency that more accurately simulate the actual usage conditions.

In the example of FIG. 2, K = 1.12, and the corrected target iron loss Wfet1 after correction may be obtained as follows: corrected target iron loss Wfet1 = 886 $\times$ 1.12 $\approx$ 990 (W). In this manner, it becomes possible to match with the iron loss of Conventional test X in FIG. 2.

Next, in the same manner as step S5 in Embodiment 1, a frequency and a current value of a current that creates the target copper loss Wcut and the corrected target iron loss Wfet1 are calculated respectively as a test frequency fex1 and a test current value Iex1 according to the simultaneous equations of Formula (2).

In this manner, by obtaining the corrected target iron loss Wfet1, it is possible to realize supply of each loss that is substantially equivalent to the superimposition test of Conventional test X. As a result, a highly reliable testing method that takes into account the nonlinear characteristics of the iron core can be provided.

In addition, in the case of simulating superimposition of one or more harmonic currents on the fundamental wave current, the target iron loss Wfet is obtained by multiplying the sum of the iron loss Wfe21 during energization of the fundamental wave current and the iron losses Wfe22m during energization of the respective harmonic currents of the predetermined orders by a coefficient of 1 or more.

The specific examples of Embodiment 1 and Embodiment 2 above have been described based on the conditions of allowable current type I of a series reactor for a phase-advancing capacitor described in Non-Patent Document 1. The present invention may also be applied to the conditions of allowable current type II. In that case, the harmonic current is a fifth harmonic of the fundamental wave and has a current value at a fundamental wave current ratio 55%. Further, the present invention may also be applied to a filter reactor into which a harmonic current flows. In the case of a filter reactor, by adjusting the combination with the capacitor, it is possible to freely select the resonance frequency, for example, setting the inflowing harmonic as an 11th harmonic, a 13th harmonic, a 23rd harmonic, etc. Furthermore, by adjusting the configuration of the filter circuit, there may be cases where a plurality of harmonic currents flow in such as the fifth harmonic and the seventh harmonic in addition to the fundamental wave current, but the present invention is similarly applicable.

The present invention is not limited to the above-described embodiments, and various modifications may be made within the scope of the claims. The technical scope of the present invention also includes embodiments obtained by appropriately combining the technical means disclosed in different embodiments.

Reference Signs List

100 Testing circuit
E1 Frequency-variable power supply
C1 Compensation capacitor
L1 Test reactor
Wcu21 Copper loss during energization of fundamental wave current
Wcu22, Wcu22m Copper loss during energization of harmonic current
Wcut Target copper loss
Wfe21 Iron loss during energization of fundamental wave current
Wfe22, Wfe22m Iron loss during energization of harmonic current
Wfet Target iron loss
Wfet1 Corrected target iron loss (target iron loss)
WT21 Total loss during energization of fundamental wave current
WT22, WT22m Total loss during energization of harmonic current
WTt, WTt1 Target total loss
200 Testing circuit of Conventional test X
Ex1 Fundamental wave power supply
Ex2 Harmonic power supply
Cx1 Capacitor for harmonic compensation
Cx2 Capacitor for fundamental wave compensation

**Claims**

1. A temperature increase testing method for a reactor (L1), **characterized by** comprising:

   a step (S3) of calculating a target copper loss (Wcut) based on a copper loss (Wcu21) during energization of a fundamental wave current at a predetermined current value and respective copper losses (Wcu22m) during energization of respective harmonic currents of predetermined orders at predetermined current values;
   a step (S4) of calculating a target iron loss (Wfet) based on an iron loss (Wfe21) during energization of the fundamental wave current and iron losses (Wfe22m) during energization of the respective harmonic currents;
   a step (S5) of calculating a frequency and a current value of a current that creates the target copper loss (Wcut) and the target iron loss (Wfet), respectively as a test frequency (fex) and a test current value (Iex); and
   a step (S6) of energizing the reactor (L1) with a test current having the test frequency (fex) and the test current value (Iex), until a temperature of a predetermined part of the reactor (L1) becomes constant.

2. The temperature increase testing method for a reactor (L 1) according to claim 1, wherein the copper loss (Wcu21) during energization of the fundamental wave current and the copper losses (Wcu22m) during energization of the respective harmonic currents are obtained in advance by calculation.

3. The temperature increase testing method for a reactor (L1) according to claim 2, further comprising:

   a step (S1) of energizing the reactor (L 1) with the fundamental wave current at the predetermined current value, and measuring a loss (WT21) during energization of the fundamental wave current; and
   a step (S2) of respectively energizing the reactor (L 1) with the respective harmonic currents of the predetermined orders at the predetermined current values, and measuring losses (WT22m) during energization of the respective harmonic currents, wherein
   the iron loss (Wfe21) during energization of the fundamental wave current is obtained by subtracting the copper loss (Wcu21) during energization of the fundamental wave current from the loss (WT21) during energization of the fundamental wave current, and
   the iron losses (Wfe22m) during energization of the respective harmonic currents are obtained by subtracting the copper losses (Wcu22m) during energization of the respective harmonic currents from the losses (WT22m) during energization of the respective harmonic currents.

4. The temperature increase testing method for a reactor (L 1) according to any one of claims 1 to 3, wherein the target copper loss (Wcut) is obtained as a sum of the copper loss (Wcu21) during energization of the fundamental wave current and the copper losses (Wcu22m) during energization of the respective harmonic currents.

5. The temperature increase testing method for a reactor (L1) according to any one of claims 1 to 4, wherein the target iron loss (Wfet) is obtained as a sum of the iron loss (Wfe21) during energization of the fundamental wave current and the iron losses (Wfe22m) during energization of the respective harmonic currents.

6. The temperature increase testing method for a reactor (L1) according to any one of claims 1 to 4, wherein the target iron loss (Wfet1) is obtained by multiplying a sum of the iron loss (Wfe21) during energization of the fundamental wave current and the iron losses (Wfe22m) during energization of the respective harmonic currents by a coefficient (K) of 1 or more.

7. The temperature increase testing method for a reactor (L 1) according to any one of claims 1 to 6, wherein the predetermined current value of the fundamental wave current is a rated current value of the reactor (L1).

8. The temperature increase testing method for a reactor (L1) according to any one of claims 1 to 7, wherein a selected order of the harmonic current is five.

**Patentansprüche**

1. Verfahren zur Temperatursteigerungsprüfung für einen Reaktor (L1), **dadurch gekennzeichnet, dass** es umfasst:

   einen Schritt (S3) des Berechnens eines Ziel-Kupferverlusts (Wcut) basierend auf einem Kupferverlust (Wcu21) während der Erregung eines Grundschwingungsstroms bei einem vorbestimmten Stromwert und jeweiliger Kupferverluste (Wcu22m) während Erregung jeweiliger Oberschwingungsströme vorbestimmter Ordnungen bei vorbestimmten Stromwerten;
   einen Schritt (S4) des Berechnens eines Ziel-Eisenverlusts (Wfet) basierend auf einem Eisenverlust (Wfe21) während Erregung des Grundschwingungsstroms und Eisenverlusten (Wfe22m) während Erregung der jeweiligen Oberschwingungsströme;
   einen Schritt (S5) des Berechnens einer Frequenz und eines Stromwerts eines Stroms, der den Zielkupferverlust (Wcut) bzw. den Zieleisenverlust (Wfet) erzeugt, als eine Testfrequenz (fex) und einen Teststromwert (Iex); und
   einen Schritt (S6) des Erregens des Reaktors (L1) mit einem Teststrom, der die Testfrequenz (fex) und den Teststromwert (Iex) aufweist, bis eine Temperatur eines vorbestimmten Teils des Reaktors (L1) konstant wird.

2. Verfahren zur Temperatursteigerungsprüfung für einen Reaktor (L 1) gemäß Anspruch 1, wobei der Kupferverlust (Wcu21) während Erregung des Grundschwingungsstroms und die Kupferverluste (Wcu22m) während Erregung der jeweiligen Oberschwingungsströme im Voraus durch Berechnung erhalten werden.

3. Verfahren zur Temperatursteigerungsprüfung für einen Reaktor (L 1) gemäß Anspruch 2, das ferner umfasst:

   einen Schritt (S1) des Erregens des Reaktors (L1) mit dem Grundschwingungsstrom bei dem vorbestimmten Stromwert und des Messens eines Verlustes (WT21) während Erregung des Grundschwingungsstroms; und
   einen Schritt (S2) des jeweiligen Erregens des Reaktors (L1) mit den jeweiligen Oberschwingungsströme der vorbestimmten Ordnungen bei den vorbestimmten Stromwerten und des Messens von Verlusten (WT22m) während Erregung der jeweiligen Oberschwingungsströme, wobei
   der Eisenverlust (Wfe21) während Erregung des Grundschwingungsstroms durch Subtrahieren des Kupferverlusts (Wcu21) während Erregung des Grundschwingungsstroms von dem Verlust (WT21) während Erregung des Grundschwingungsstroms erhalten wird und
   die Eisenverluste (Wfe22m) während Erregung der jeweiligen Oberschwingungsströme durch Subtrahieren der Kupferverluste (Wcu22m) während Erregung der jeweiligen Oberschwingungsströme von den Verlusten (WT22m) während Erregung der jeweiligen Oberschwingungsströme erhalten werden.

4. Verfahren zur Temperatursteigerungsprüfung für einen Reaktor (L1) gemäß einem der Ansprüche 1 bis 3, wobei der Ziel-Kupferverlust (Wcut) als eine Summe des Kupferverlusts (Wcu21) während Erregung des Grundschwingungsstroms und der Kupferverluste (Wcu22m) während Erregung der jeweiligen Oberschwingungsströme erhalten wird.

5. Verfahren zur Temperatursteigerungsprüfung für einen Reaktor (L1) gemäß einem der Ansprüche 1 bis 4, wobei der Ziel-Eisenverlust (Wfet) als Summe des Eisenverlusts (Wfe21) während Erregung des Grundschwingungsstroms und der Eisenverluste (Wfe22m) während Erregung der jeweiligen Oberschwingungsströme erhalten wird.

6. Verfahren zur Temperatursteigerungsprüfung für einen Reaktor (L1) gemäß einem der Ansprüche 1 bis 4, wobei der Ziel-Eisenverlust (Wfet1) durch Multiplizieren einer Summe des Eisenverlusts (Wfe21) während Erregung des Grundschwingungsstroms und der Eisenverluste (Wfe22m) während Erregung der jeweiligen Oberschwingungsströme mit einem Koeffizienten (K) von 1 oder mehr erhalten wird.

7. Verfahren zur Temperatursteigerungsprüfung für einen Reaktor (L1) gemäß einem der Ansprüche 1 bis 6, wobei der vorbestimmte Stromwert des Grundschwingungsstroms ein Nennstromwert des Reaktors (L1) ist.

8. Verfahren zur Temperatursteigerungsprüfung für einen Reaktor (L1) gemäß einem der Ansprüche 1 bis 7, wobei eine ausgewählte Ordnung des Oberschwingungsstroms fünf ist.

**Revendications**

1. Procédé de test d'augmentation de température pour un réacteur (L1), **caractérisé en ce qu'**il comprend :

   une étape (S3) de calcul d'une perte de cuivre cible (Wcut) basée sur une perte de cuivre (Wcu21) lors de l'excitation d'un courant d'onde fondamentale à une valeur de courant prédéterminée et sur des pertes de cuivre respectives (Wcu22m) lors de l'excitation de courants harmoniques respectifs d'ordres prédéterminés à des valeurs de courant prédéterminées ;
   une étape (S4) de calcul d'une perte de fer cible (Wfet) basée sur une perte de fer (Wfe21) lors de l'excitation du courant d'onde fondamentale et sur des pertes de fer (Wfe22m) lors de l'excitation des courants harmoniques respectifs ;
   une étape (S5) de calcul d'une fréquence et d'une valeur de courant d'un courant créant la perte de cuivre cible (Wcut) et la perte de fer cible (Wfet), respectivement sous forme de fréquëtice d'essai (fex) et de valeur de courant d'essai (Iex) ; et
   une étape (S6) d'excitation du réacteur (L1) avec un courant d'essai ayant la fréquence d'essai (fex) et la valeur du courant d'essai (Iex), jusqu'à ce que la température d'une partie prédéterminée du réacteur (L1) devienne constante.

2. Procédé de test d'augmentation de température pour un réacteur (L1) selon la revendication 1, dans lequel les pertes de cuivre (Wcu21) lors de l'excitation du courant d'onde fondamentale et les pertes de cuivre (Wcu22m) lors de l'excitation des courants harmoniques respectifs sont obtenues à l'avance par calcul.

3. Procédé de test d'augmentation de température pour un réacteur (L1) selon la revendication 2, comprenant en outre :

   une étape (S1) d'excitation du réacteur (L1) avec le courant d'onde fondamentale à la valeur de courant prédéterminée et la mesure d'une perte (WT21) lors de l'excitation du courant d'onde fondamentale ; et
   une étape (S2) consistant à exciter respectivement le réacteur (L1) avec les courants harmoniques respectifs des ordres prédéterminés aux valeurs de courant prédéterminées et à mesurer les pertes (WT22m) lors de l'excitation des courants harmoniqus respectifs, dans lequel
   les pertes de fer (Wfe21) lors de l'excitation du courant d'onde fondamentale sont obtenues en soustrayant les pertes de cuivre (Wcu21) lors de l'excitation du courant d'onde fondamentale des pertes (WT21) lors de l'excitation du courant d'onde fondamentale, et
   les pertes de fer (Wfe22m) lors de l'excitation des courants harmoniques respectifs sont obtenues en soustrayant les pertes de cuivre (Wcu22m) lors de l'excitation des courants harmoniques respectifs des pertes (WT22m) lors de l'excitation des courants harmoniques respectifs.

4. Procédé de test d'augmentation de température pour un réacteur (L1) selon une quelconque des revendications 1 à 3, dans lequel la perte de cuivre cible (Wcut) est obtenue comme la somme de la perte de cuivre (Wcu21) lors de l'excitation du courant d'onde fondamentale et des pertes de cuivre (Wcu22m) lors de l'excitation des courants harmoniques respectifs.

5. Procédé de test d'augmentation de température pour un réacteur (L1) selon une quelconque des revendications 1 à 4, dans lequel la perte de fer cible (Wfet) est obtenue comme la somme de la perte de fer (Wfe21) lors de l'excitation du courant d'onde fondamentale et des pertes de fer (Wfe22m) lors de l'excitation des courants harmoniques respectifs.

6. Procédé de test d'augmentation de température pour un réacteur (L1) selon une quelconque des revendications 1 à 4, dans lequel la perte fer cible (Wfetl) est obtenue en multipliant la somme des pertes de fer (Wfe21) lors de l'excitation du courant d'onde fondamentale et des pertes de fer (Wfe22m) lors de l'excitation des courants harmoniques respectifs par un coefficient (K) supérieur ou égal, à 1.

7. Procédé de test d'augmentation de température pour un réacteur (L1) selon une quelconque des revendications 1 à 6, dans lequel la valeur de courant prédéterminée du courant d'onde fondamentale est une valeur de courant nominal du réacteur (L1).

8. Procédé de test d'augmentation de température pour un réacteur (L1) selon une quelconque des revendications 1 à 7, dans lequel l'ordre sélectionné du courant harmonique est cinq.

100

FIG. 1

(W)

| | Conventional test X | | Fundamental wave | | Fifth harmonic | | Total | Conventional test Y | | Embodiment 1 | | Embodiment 2 | |
|---|---|---|---|---|---|---|---|---|---|---|---|---|---|
| Copper loss | Wcux | 882 | Wcu21 | 772 | Wcu22 | 110 | 882 | Wcuy | 1150 | Wcut | 882 | Wcut | 882 |
| Iron loss | Wfex | 990 | Wfe21 | 415 | Wfe22 | 471 | 886 | Wfey | 618 | Wfet | 886 | Wfet1 | 990 |
| Total loss | WTx | 1872 | WT21 | 1187 | WT22 | 581 | 1768 | WTy | 1768 | WTt | 1768 | WTt1 | 1872 |

FIG. 2

EP 4 266 067 B1

31

$\theta = 0°$

32

$\theta = 60°$

33

$\theta = 15°$

# FIG. 3

200

Ex1

Tx1     Tx2

Ex2     Cx1

Cx2

Lx2     Lx1

# FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016133355 A